# EUROPEAN PATENT APPLICATION

(11) **EP 3 206 306 A1**
(43) Date of publication of application: **16.08.2017**
(21) Application number: 14884594.4
(22) Date of filing: 11.12.2014
(51) Int. Cl.: H04B 7/00, H04B 1/02, H01R 31/06, H01R 13/02

(54) **RADIO FREQUENCY UNIT**

(30) Priority: 11.10.2014 CN 201420587665 U
(71) Applicant: ZTE Corporation, Shenzhen, Guangdong 518057 (CN)
(72) Inventor: KANG, Yulong, Shenzhen Guangdong 518057 (CN); SHAO, Xiaobing, Shenzhen Guangdong 518057 (CN)
(74) Representative: Winter, Brandl, Fürniss, Hübner, Röss, Kaiser, Polte - Partnerschaft mbB
(86) International application number: PCT/CN2014/093617
(87) International publication number: WO 2015/131600

(57) **Abstract**

Disclosed is a radio frequency unit, including a power amplification module (9), a filtering module and a signal connector (1); where one end (A) of the signal connector is connected to the filtering module, and the other end (B) is connected to the power amplification module; the power amplification module is provided with a power amplification connector (2); a guide structure for guiding the power amplification connector to be coaxially aligned with the signal connector is formed on one end of the signal connector connected with the power amplification module; and through the guide structure, the power amplification connector is coaxially connected with the signal connector. Through the above technical solution, the utility model solves the problem that an existing radio frequency unit cannot satisfy an assembly requirement due to small axial tolerance and radial tolerance in an assembly process. The connection between the power amplification module and the filtering module through the signal connector is facilitated by means of the guide structure used for guiding the power amplification connector and the signal connector to be coaxially aligned. Compared with an existing signal connector, the utility model has the advantages of low cost, space saving, flexible installation mode and simple technology.

## Description

### TECHNICAL FIELD

The utility model relates to the field of communication devices, and in particular relates to a radio frequency unit.

### BACKGROUND

In a base station communication product, a radio frequency unit is mainly used for receiving and transmitting a wireless signal, and includes a carrier frequency processing module, a power amplification module, a filtering module and the like. The carrier frequency processing module is connected with the filtering module through a small signal radio frequency connector for receiving and transmitting a radio frequency signal, and the power amplification module is connected with the filtering module through a large signal radio frequency connector for transmitting a high-power signal.

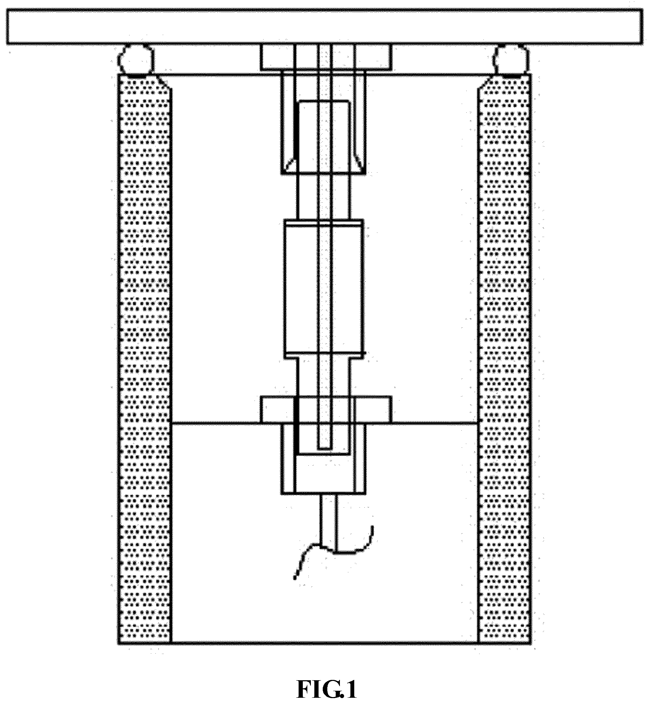

Fig. 1 is a schematic structural diagram illustrating an existing radio frequency unit. As shown in Fig. 1, the existing radio frequency unit has the following problems: the large signal radio frequency connector between the power amplification module and the filtering module has high cost, cannot meet a system design requirement in power capacity, has large consumption, occupies too large area, has too small axial tolerance and radial tolerance and cannot meet an assembly requirement.

### SUMMARY

The utility model provides a radio frequency unit which solves the problem that an existing radio frequency unit cannot satisfy an assembly requirement due to small axial tolerance and radial tolerance in an assembly process.

To solve the above technical problem, the utility model provides a radio frequency unit, including a power amplification module, a filtering module and a signal connector; where
one end of the signal connector is connected to the filtering module, and the other end is connected to the power amplification module;
the power amplification module is provided with a power amplification connector; a guide structure for guiding the power amplification connector to be coaxially aligned with the signal connector is formed on one end of the signal connector connected with the power amplification module; and through the guide structure, the power amplification connector is coaxially connected with the signal connector.

In one embodiment of the utility model, the guide structure is an arc-shaped structure, and the arc-shaped structure is formed on an outer edge of an end surface of the signal connector.

In one embodiment of the utility model, the guide structure is a convex structure; an inner edge of the convex structure has a slope; and the convex structure is formed on the end surface of the signal connector along the outer edge of the end surface of the signal connector.

In one embodiment of the utility model, the signal connector is a signal pin; the signal pin includes a male connector, a pin body, an elastic component and a fixing component used for fixing the signal pin;
the fixing component is wrapped on the pin body; the elastic component is arranged in the pin body; one end of the pin body is provided with an opening; a tail of the male connector is a cambered surface, and is in contact with the elastic component through the opening; a head of the male connector is provided with the arc-shaped structure, and a certain gap is reserved between the male connector and the opening.

In one embodiment of the utility model, the power amplification connector is a signal hole, and a tail of the signal hole is connected to a signal output end of the power amplification module.

In one embodiment of the utility model, the signal connector is a signal hole; the signal hole includes a hole body, a female connector, and a fixing component used for fixing the hole body.

The fixing component is wrapped on the hole body; one end of the hole body is connected to a tail of the female connector; and a head of the female connector is provided with the convex structure.

In one embodiment of the utility model, the power amplification connector is a signal pin, and a tail of the signal pin is connected to a signal output end of the power amplification module.

In one embodiment of the utility model, one end of the signal connector is directly connected to a signal input end of the filtering module.

In one embodiment of the utility model, the radio frequency unit further includes an outer conductor which acts as a signal transmission backflow place and has a shielding effect; the outer conductor includes a metal shielding layer and a conductive rubber ring; and the conductive rubber ring is arranged between the metal shielding layer and the power amplification module.

In one embodiment of the utility model, the metal shielding layer includes a filtering module cavity and a filtering module cover plate, or the metal shielding layer includes a filtering module cavity.

The conductive rubber ring is directly put on the filtering module cavity or the filtering module cover plate, or the conductive rubber ring is arranged in a fluid dispensing mode on the filtering module cavity or the filtering module cover plate.

The utility model has the following beneficial effects:

The utility model provides a radio frequency unit. The connection between the power amplification module and the filtering module through the signal connector is facilitated by means of the guide structure used for guiding the power amplification connector and the signal connector to be coaxially aligned. Compared with an existing signal connector, the utility model has the advantages of low cost, bearing of high power, good port standing wave, low insertion loss, wide frequency band, space saving, flexible installation mode and simple technology, has high processing precision, good device consistency and processibility, can be applied to an ordinary PCB (Printed Circuit Board), is formed in one step by adopting a processing technology of SMT (Surface Mount Technology), and is suitable for batch production. In addition, the connection with a microstrip transmission line on a radio frequency circuit board is made through welding on the radio frequency circuit board, so as to realize the connection between the microstrip transmission line on the radio frequency circuit board and an external device, i.e., realize signal transmission. A novel radio frequency connector and a corresponding conductive region on a duplexer cavity are connected together through a standard structure adapter which can be selected from standard structure adapters with various structural forms, so as to flexibly design an adapter coupling mode.

### DESCRIPTION OF THE DRAWINGS

Fig. 1 is a schematic structural diagram illustrating an existing radio frequency unit;
Fig. 2a is a schematic structural diagram illustrating a signal connector provided in embodiment 1 of the utility model;
Fig. 2b and Fig. 2c are schematic structural diagrams respectively illustrating a power amplification connector in a horizontal direction and a vertical direction provided in embodiment 1 of the utility model;
Fig. 3a and Fig. 3b are schematic sectional views illustrating an assembly process of a radio frequency unit provided in embodiment 1 of the utility model;
Fig. 4a and Fig. 4b are schematic sectional views illustrating an assembly process of a radio frequency unit provided in embodiment 1 of the utility model;
Fig. 5a is a schematic structural diagram illustrating a signal connector provided in embodiment 2 of the utility model;
Fig. 5b and Fig. 5c are schematic structural diagrams illustrating a power amplification connector in a horizontal direction and a vertical direction provided in embodiment 2 of the utility model;
Fig. 6a and Fig. 6b are schematic sectional views illustrating an assembly process of a radio frequency unit provided in embodiment 2 of the utility model; and
Fig. 7a and Fig. 7b are schematic sectional views illustrating an assembly process of a radio frequency unit provided in embodiment 2 of the utility model.

### DETAILED DESCRIPTION

The technical solutions in the embodiments of the utility model will be clearly and fully described below in combination with the drawings in the embodiments of the utility model. Apparently, the described embodiments are merely part of the embodiments of the utility model, not all of the embodiments. Based on the embodiments in the utility model, all other embodiments obtained by those ordinary skilled in the art without contributing creative labor will belong to the protection scope of the utility model.

The utility model is further detailed below through specific embodiments in combination with drawings.

To enable the radio frequency unit to satisfy the assembly requirement in the assembly process, the utility model provides a radio frequency unit, including a power amplification module and a filtering module, and further including a signal connector; one end of the signal connector is connected to the filtering module, i.e., a large-signal connector is arranged on one side of the filtering module; and the other end of the signal connector is connected to the power amplification module, so that the filtering module and the power amplification module are connected through the signal connector; the power amplification module is provided with a power amplification connector; and the signal connector is connected with the power amplification module through the power amplification connector. To enable the signal connector and the power amplification connector to satisfy the assembly requirement in the assembly process, a guide structure is formed on one connecting end of the signal connector and the power amplification module; when the signal connector is connected with the power amplification connector, the guide structure can be used for guiding the power amplification connector and the signal connector to be coaxially aligned; and through the guide structure, the power amplification connector is coaxially connected with the signal connector, i.e., blind insertion between the signal connector and the power amplification connector on the power amplification module through tolerance design is realized, so as to satisfy the assembly requirement. The power amplification module may be a power amplification PCB, and the filtering module may be a filter.

### Embodiment 1:

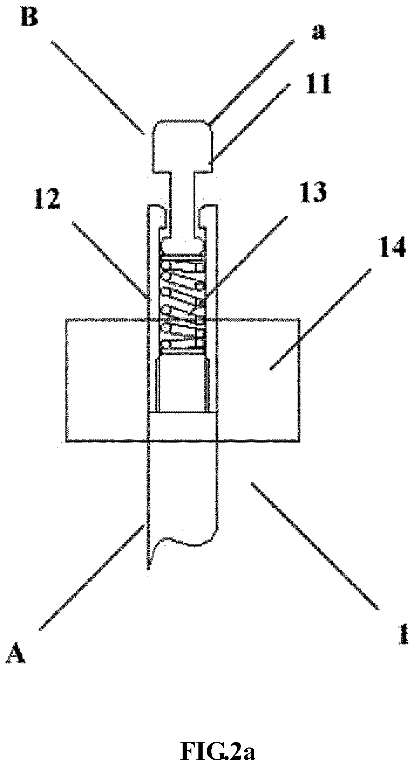

Fig. 2a is a schematic structural diagram illustrating a signal connector provided in embodiment 1 of the utility model. As shown in Fig. 2a, the signal connector 1 is arranged on one side of the filtering module; a shape and a structure of one end A of the signal connector 1 connected with the filtering module can be designed by manufacturers; the guide structure formed on one end B of the signal connector 1 connected with the power amplification module is an arc-shaped structure a; and the arc-shaped structure a is formed on an outer edge of an end surface of the signal connector 1. For example, a fillet is arranged on the outer edge of the end surface. Further, if the larger the radius of the arc-shaped structure a is, the closer the distance from the arc-shaped structure a to a dome arranged on the end surface, then the signal connector and the power amplification connector are coaxially connected through the arc-shaped structure a.

In the above technical solution, the signal connector 1 is a signal pin; the signal pin includes a male connector 11, a pin body 12, an elastic component 13 and a fixing component 14, wherein the male connector 11 and the pin body 12 may be copper cylinders; the fixing component 14 is wrapped on the pin body 12 and used for fixing the signal pin; the elastic component 13 is arranged in the pin body 12 and can be used for increasing requirements for the axial tolerance and the radial tolerance; a head of the male connector 11 is provided with the arc-shaped structure a; one end of the pin body 12 is provided with an opening; a tail of the male connector 11 is in contact with the elastic component 13 through the opening, and is a cambered surface; a certain gap is reserved between the male connector 11 and the opening; the other end of the pin body 12 is connected with the filtering module; and the shape and the structure of the pin body 12 can be designed by the manufacturers.

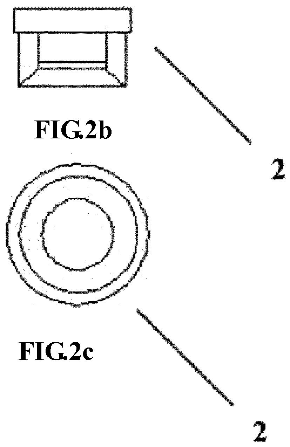

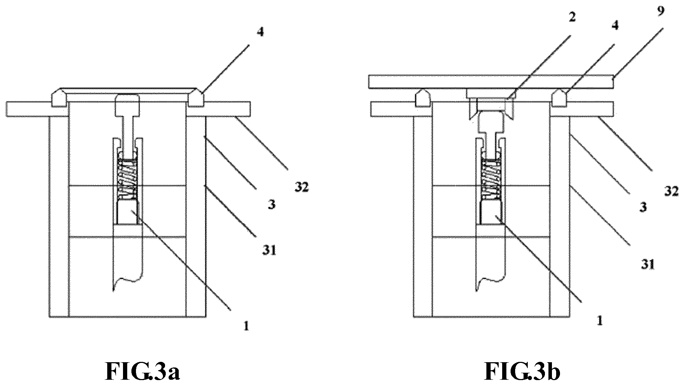

Fig. 2b and Fig. 2c are schematic structural diagrams respectively illustrating a power amplification connector in a horizontal direction and a vertical direction provided in embodiment 1 of the utility model. As shown in Fig. 2b and Fig. 2c, structures of the power amplification connector 2 in the horizontal direction and the vertical direction are respectively listed. The power amplification connector 2 is a female connector and is arranged on one side of the power amplification module 9 (as shown in Fig. 3b). The power amplification connector 2 is a signal hole, a head of the signal hole is provided with a guide groove, and a tail of the signal hole is connected to a signal output end of the power amplification module 9.

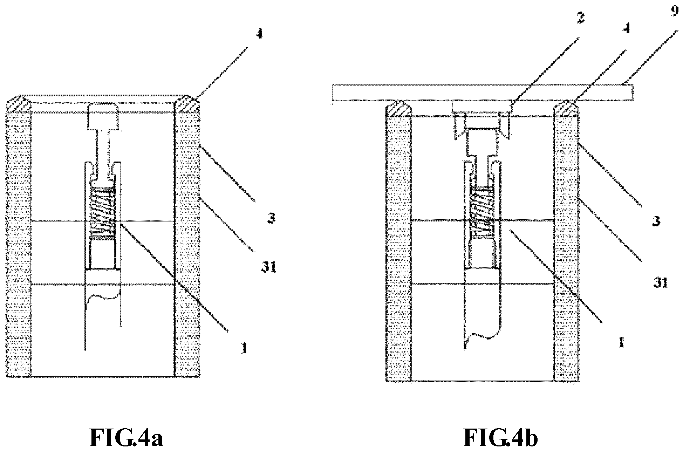

Fig. 3a and Fig. 3b are schematic sectional views illustrating an assembly process of a radio frequency unit provided in embodiment 1 of the utility model as shown in Fig. 3a and Fig. 3b. Fig. 4a and Fig. 4b are schematic sectional views illustrating an assembly process of a radio frequency unit provided in embodiment 1 of the utility model. As shown in Fig. 4a and Fig. 4b, according to the above signal connector (signal pin) 1 and the power amplification connector (signal hole)2, the assembly process of the radio frequency unit is as follows: firstly, at one side of the filtering module, the tail of the signal pin is directly connected to the signal input end of the filtering module so as to serve as a large-signal transmission wire; the shape and the structure of the signal pin can be designed or freely changed according to the filtering module cavity; an arc-shaped structure is arranged on the male connector of the signal pin; the elastic component in the signal pin can be used for increasing the requirements for axial tolerance and the radial tolerance; secondly, at one side of the power amplification module, the tail of the signal hole is connected to the signal output end of the power amplification module; for example, the tail of the signal hole is welded on an output signal wire of the power amplification PCB; the head of the signal hole is provided with the guide groove; the shape of the guide groove is similar to a bowl and can be used for increasing the axial tolerance; finally, the power amplification module is directly placed on the filtering module; the arc-shaped structure can guide the power amplification connector and the signal connector to be coaxially aligned and can enable the power amplification connector and the signal connector to be matched, so as to complete coaxial connection between the power amplification connector and the signal connector, i.e., quickly realize blind insertion between the signal connector and the power amplification connector on the power amplification module through tolerance design, so as to solve the problem that an existing radio frequency unit cannot satisfy an assembly requirement due to small axial tolerance and radial tolerance.

In the above technical solution, the signal connector 1 and the power amplification connector 2 form an inner core of the radio frequency unit. The radio frequency unit further includes an outer conductor which acts as a signal transmission backflow place and has a shielding effect; the outer conductor includes a metal shielding layer 3 and a conductive rubber ring 4; and the conductive rubber ring 4 is arranged between the metal shielding layer 3 and the power amplification module. The metal shielding layer 3 may include a filtering module cavity 31 and a filtering module cover plate 32, or the metal shielding layer 3 may only include a filtering module cavity 31. If the conductive rubber ring 4 is a conductive O-ring, the conductive rubber ring 4 can be directly placed on the filtering module cavity 31 or the filtering module cover plate 32; and if the conductive rubber ring 4 is formed in a fluid dispensing mode, the conductive rubber ring 4 can be arranged in the fluid dispensing mode on the filtering module cavity 31 or the filtering module cover plate 32. It should be noted that in the present embodiment, the outer conductor may serve as a ground layer of the signal connector and the power amplification connector without installing an additional radio frequency linkage and other shielding layers. In combination with the above assembly process, the difference between Figs. 3a and 3b and Figs. 4a and 4b is that, in Figs. 3a and 3b, the outer conductor of the radio frequency unit includes a filtering module cover plate 32 and the conductive rubber ring 4 is arranged on the filtering module cover plate 32, while in the Figs. 4a and 4b, the outer conductor of the radio frequency unit does not include a filter cover plate 32 and the conductive rubber ring 4 is arranged on the filtering module cavity.

The present embodiment provides a radio frequency unit. The connection between the power amplification module and the filtering module through the signal connector is facilitated by means of the arc-shaped structure used for guiding the power amplification connector and the signal connector to be coaxially aligned. Compared with an existing signal connector, the present embodiment has the advantages of low cost, space saving, flexible installation mode and simple technology.

### Embodiment 2:

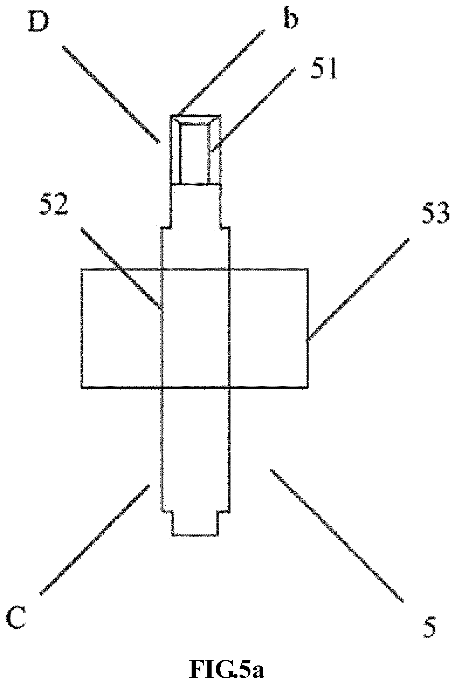

Fig. 5a is a schematic structural diagram illustrating a signal connector provided in embodiment 2 of the utility model. As shown in Fig. 5a, the signal connector 5 is arranged on one side of the filtering module; the shape and the structure of one end C of the signal connector 5 connected with the filtering module can be designed by the manufacturers; the guide structure formed on one end D of the signal connector 5 connected with the power amplification module is a convex structure b; an inner edge of the convex structure b has a slope; a direction of the slope is outward; the convex structure b is formed on the end surface of the signal connector 5 along the outer edge of the end surface of the signal connector 5; for example, the end surface is designed in a cross shape or other shapes with a guide function, so as to increase the requirements for the axial tolerance and the radial tolerance; and the signal connector and the power amplification connector are coaxially connected through the convex structure b.

In the above technical solution, the signal connector 5 is a signal hole; and the signal hole includes a hole body 51, a female connector 52, and a fixing component 53, wherein the hole body 51 and the female connector 52 may be copper cylinders; the fixing component 53 is wrapped on the hole body 51 and used for fixing the signal hole; one end of the hole body 51 is connected to the tail of the female connector 52, and the other end of the hole body 51 is connected to the filtering module; the shape and the structure of the hole body 51 can be designed by the manufacturers; and the head of the female connector 52 is provided with the convex structure b.

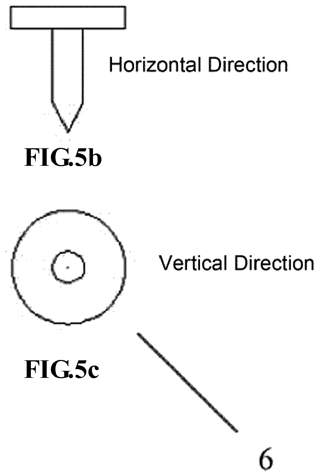

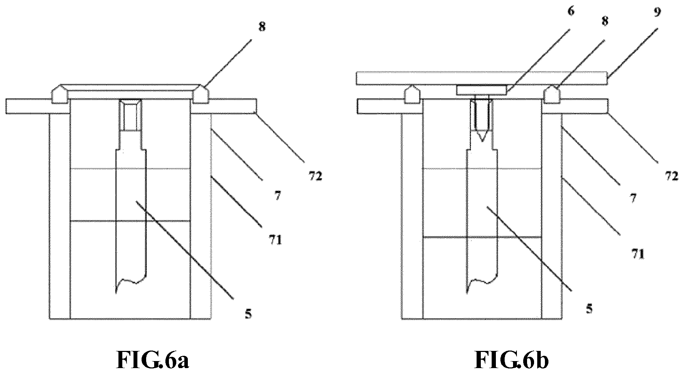

Fig. 5b and Fig. 5c are schematic structural diagrams illustrating a power amplification connector provided in embodiment 2 of the utility model in a horizontal direction and a vertical direction. As shown in Fig. 5b and Fig. 5c, structures of the power amplification connector 6 in the horizontal direction and the vertical direction are respectively listed. The power amplification connector 6 is a male connector and is arranged on one side of the power amplification module 9 (as shown in Fig. 6b). The power amplification connector 6 is a signal pin, and a tail of the signal pin is connected to a signal output end of the power amplification module, e.g., welded to the signal output end of the power amplification module 9.

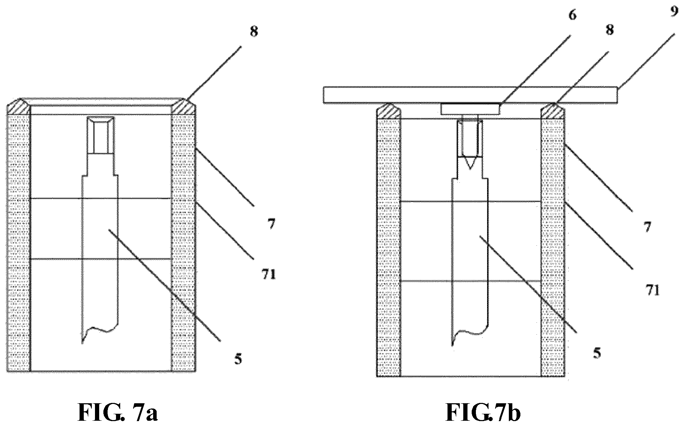

Fig. 6a and Fig. 6b are schematic sectional views illustrating an assembly process of a radio frequency unit provided in embodiment 2 of the utility model as shown in Fig. 6a and Fig. 6b. Fig. 7a and Fig. 7b are schematic sectional views illustrating a structure of a radio frequency unit provided in embodiment 2 of the utility model. As shown in Fig. 7a and Fig. 7b, according to the above signal connector (signal hole) 5 and the power amplification connector (signal pin) 6, the assembly process of the radio frequency unit is as follows: firstly, at one side of the filtering module, the tail of the signal hole is directly connected to the signal input end of the filtering module so as to serve as a large-signal transmission wire; the shape and the structure of the signal hole can be designed or freely changed according to the filtering module cavity; a convex structure is arranged on the head of the signal hole, i.e., the end surface of the head of the signal hole is designed in a cross shape or other shapes with a guide function, so as to increase the requirements for the axial tolerance and the radial tolerance; secondly, at one side of the power amplification module, the tail of the signal pin is connected to the signal output end of the power amplification module; for example, the tail of the signal pin is welded on an output signal wire of the power amplification PCB; finally, the power amplification module is directly placed on the filtering module; the convex structure can guide the power amplification connector and the signal connector to be coaxially aligned and can enable the power amplification connector and the signal connector to be matched, so as to complete coaxial connection between the power amplification connector and the signal connector, i.e., quickly realize blind insertion between the signal connector and the power amplification connector on the power amplification module through tolerance design, so as to solve the problem that an existing radio frequency unit cannot satisfy an assembly requirement due to small axial tolerance and radial tolerance.

In the above technical solution, the signal connector 5 and the power amplification connector 6 form an inner core of the radio frequency unit. The radio frequency unit further includes an outer conductor which acts as a signal transmission backflow place and has a shielding effect; the outer conductor includes a metal shielding layer 7 and a conductive rubber ring 8; and the conductive rubber ring 8 is arranged between the metal shielding layer 7 and the power amplification module. The metal shielding layer 7 may include a filtering module cavity 71 and a filtering module cover plate 72, or the metal shielding layer 7 may only include a filtering module cavity 71. If the conductive rubber ring 8 is a conductive O-ring, the conductive rubber ring 8 can be directly placed on the filtering module cavity 71 or the filtering module cover plate 72; and if the conductive rubber ring 8 is formed in a fluid dispensing mode, the conductive rubber ring 8 can be arranged in the fluid dispensing mode on the filtering module cavity 71 or the filtering module cover plate 72. It should be noted that in the present embodiment, the outer conductor may serve as a ground layer of the signal connector and the power amplification connector without installing an additional radio frequency linkage and other shielding layers. In the present embodiment, the inner core and the outer conductor can adopt tolerance design to satisfy interference fit in mutual connection between the power amplification module and the filtering module, so as to realize reliable blind insertion. In combination with the above assembly process, the difference between Figs. 6a and 6b and Figs. 7a and 7b is that, in Figs. 6a and 6b, the outer conductor of the radio frequency unit includes a filtering module cover plate 72 and the conductive rubber ring 8 is arranged on the filtering module cover plate 72, while in the Figs. 7a and 7b, the outer conductor of the radio frequency unit does not include a filter cover plate 72 and the conductive rubber ring 8 is arranged on the filtering module cavity. In the present embodiment, the inner core and the outer conductor can adopt tolerance design to satisfy interference fit in mutual connection between the power amplification module and the filtering module, so as to realize reliable blind insertion.

The present embodiment provides a radio frequency unit. The connection between the power amplification module and the filtering module through the signal connector is facilitated by means of the convex structure used for guiding the power amplification connector and the signal connector to be coaxially aligned. Compared with an existing signal connector, the present embodiment has the advantages of low cost, space saving, flexible installation mode and simple technology.

The above contents are further detailed descriptions of the utility model in combination with specific preferred embodiments. However, it cannot be considered that the concrete implementation of the utility model is only limited to these descriptions. For those ordinary skilled in the art to which the utility model belongs, several simple deductions or replacements may be made without departing from the conception of the utility model, all of which shall be considered to belong to the protection scope of the utility model.

### Industrial Applicability

Based on the radio frequency unit provided in the utility model, the connection between the power amplification module and the filtering module through the signal connector is facilitated by means of the guide structure used for guiding the power amplification connector and the signal connector to be coaxially aligned. Compared with an existing signal connector, the utility model has the advantages of low cost, bearing of high power, good port standing wave, low insertion loss, wide frequency band, space saving, flexible installation mode and simple technology, has high processing precision, good device consistency and processibility, can be applied to an ordinary PCB, is formed in one step by adopting a processing technology of SMT, and is suitable for batch production. In addition, the connection with a microstrip transmission line on a radio frequency circuit board is made through welding on the radio frequency circuit board, so as to realize the connection between the microstrip transmission line on the radio frequency circuit board and an external device, i.e., realize signal transmission. A novel radio frequency connector and a corresponding conductive region on a duplexer cavity are connected together through a standard structure adapter which can be selected from standard structure adapters with various structural forms, so as to flexibly design an adapter coupling mode.

## Claims

1. A radio frequency unit, comprising a power amplification module, a filtering module and a signal connector; wherein
one end of the signal connector is connected to the filtering module, and the other end is connected to the power amplification module;
the power amplification module is provided with a power amplification connector; a guide structure for guiding the power amplification connector to be coaxially aligned with the signal connector is formed on one end of the signal connector connected with the power amplification module; and through the guide structure, the power amplification connector is coaxially connected with the signal connector.

2. The radio frequency unit according to claim 1, wherein the guide structure is an arc-shaped structure, and the arc-shaped structure is formed on an outer edge of an end surface of the signal connector.

3. The radio frequency unit according to claim 1, wherein the guide structure is a convex structure; an inner edge of the convex structure has a slope; and the convex structure is formed on the end surface of the signal connector along the outer edge of the end surface of the signal connector.

4. The radio frequency unit according to claim 2, wherein the signal connector is a signal pin;
the signal pin comprises a male connector, a pin body, an elastic component and a fixing component used for fixing the signal pin;
the fixing component is wrapped on the pin body; the elastic component is arranged in the pin body; one end of the pin body is provided with an opening; a tail of the male connector is a cambered surface, and is in contact with the elastic component through the opening; a head of the male connector is provided with the arc-shaped structure, and a certain gap is reserved between the male connector and the opening.

5. The radio frequency unit according to claim 2 or 4, wherein the power amplification connector is a signal hole, and a tail of the signal hole is connected to a signal output end of the power amplification module.

6. The radio frequency unit according to claim 3, wherein the signal connector is a signal hole;
the signal hole comprises a hole body, a female connector, and a fixing component used for fixing the hole body;
the fixing component is wrapped on the hole body; one end of the hole body is connected to a tail of the female connector; and a head of the female connector is provided with the convex structure.

7. The radio frequency unit according to claim 3 or 6, wherein the power amplification connector is a signal pin, and a tail of the signal pin is connected to a signal output end of the power amplification module.

8. The radio frequency unit according to any one of claims 1-3, wherein one end of the signal connector is directly connected to a signal input end of the filtering module.

9. The radio frequency unit according to any one of claims 1-3, wherein the radio frequency unit further comprises an outer conductor which acts as a signal transmission backflow place and has a shielding effect; the outer conductor comprises a metal shielding layer and a conductive rubber ring; and the conductive rubber ring is arranged between the metal shielding layer and the power amplification module.

10. The radio frequency unit according to claim 9, wherein the metal shielding layer comprises a filtering module cavity and a filtering module cover plate, or the metal shielding layer comprises a filtering module cavity;
the conductive rubber ring is directly put on the filtering module cavity or the filtering module cover plate, or the conductive rubber ring is arranged in a fluid dispensing mode on the filtering module cavity or the filtering module cover plate.
